**Europäisches Patentamt**

**European Patent Office**

**Office européen des brevets**

(11) Veröffentlichungsnummer: **0 213 426**
**A1**

## (12) EUROPÄISCHE PATENTANMELDUNG

(21) Anmeldenummer: **86110758.9**

(22) Anmeldetag: **04.08.86**

(51) Int. Cl.⁴ **H01L 33/00 , G02B 6/42**

(30) Priorität: **30.08.85 DE 3531135**

(43) Veröffentlichungstag der Anmeldung:
**11.03.87 Patentblatt 87/11**

(84) Benannte Vertragsstaaten:
**DE FR GB IT**

(71) Anmelder: **Siemens Aktiengesellschaft Berlin und München**
**Wittelsbacherplatz 2**
**D-8000 München 2(DE)**

(72) Erfinder: **Frenkel, Ferdinand, Dr., Dipl.-Phys.**
**Elisenstrasse 10**
**D-8900 Augsburg(DE)**
Erfinder: **Prussas, Herbert, Dipl.-Ing.**
**Mozartring 11**
**D-8069 Reichertshausen(DE)**
Erfinder: **Rapp, Lothar**
**Gabriele-Münter-Strasse 7**
**D-8000 München 71(DE)**

(54) **Gehäuse mit Bodenwanne und Aussendeckel für ein elektrisches Schaltungsbauteil.**

(57) Gehäuse(1, 4, 5, 6) mit einer Bodenwanne(1, 4) und mit einem -bevorzugt hermetisch dicht -auf der Bodenwanne (1, 4) aufsitzendem Außendeckel(5, 6) für ein elektrisches, im Betrieb Verlustwärme abgebendes Schaltungsbauteil(11, 17), z.B. für eine Lichtsendediode (17) und/oder für einen Halbleiter-Chip (11). Das Schaltungsbauteil(11, 17) ist am Boden(1) der Bodenwanne(1, 4) befestigt. Die Verlustwärme wird im Betrieb zumindest zu einem erheblichen Teil über einen Wärmeableitkörper(5, 6) des Gehäuses-(1, 4, 5, 6) an eine Gehäuse-Außenoberfläche, bevorzugt über den gut wärmeleitenden Außendeckel(5, 6) als Wärmeableitkörper(5, 6) an die Außendeckel-(6)-Außenoberfläche, und von dort weiter an ein das Gehäuse umströmendes Kühlmedium, bevorzugt, Kühlluft, abzugeben.

Die Verlustwärme-Ableitung zum Kühlmedium wird mit besonders einfachen Mitteln dadurch verbessert, daß zumindest ein Teil sowohl der Boden-(1)-Innenoberfläche als auch der Bodenwanne-Seitenwände(4) der, insgesamt gesehen, relativ - schlecht wärmeleitenden Bodenwanne(1, 4) mit einem gut wärmeleitenden Auskleidungsblech(2) ausgekleidet ist, wobei das Auskleidungsblech(2) jeweils einen gut wärmeleitenden Übergangsabschnitt sowohl zum Schaltungsbauteil(11, 17) hin als auch einem zum Wärmeableitkörper(5, 6) hin aufweist.

**FIG 1**

**Gehäuse mit Bodenwanne und Außendeckel für ein elektrisches Schaltungsbauteil.**

Die Erfindung geht von einem speziellen, im Oberbegriff des Patentanspruchs 1 definierten Gehäuse aus, welches für sich z.B. aus der DE-OS 33 37 131 vorbekannt ist.

Die Erfindung hat die Aufgabe, mit möglichst wenig Aufwand die Kühlung des am Boden im Gehäuse-Inneren angebrachten Schaltungsbauteiles dann zu verbessern, wenn große Teile des Gehäuses, z.B. die ganze Bodenwanne, zu - schlecht wärmeleitend sind, um im Betrieb die Verlustwärme, zumindest einen hohen Anteil davon, des Schaltungsbauteiles, an das umströmende Kühlmedium abzuleiten. Dabei kann das Verlustwärme abgebende Schaltungsbauteil selber aus mehreren diskret im Gehäuse angebrachten Baukörpern bestehen, also z.B. aus einer 1W Verlustleistung aufweisenden Lichtsendediode sowie einen dazugehörenden, selber auch eine ähnlich hohe Verlustleistung aufweisenden Treiber-Chip als Hochfrequenz-Vorverstärker der Lichtsendediode. Zum sicheren Betrieb eines solchen Schaltungsteiles müssen die beiden Baukörper ausreichend gekühlt werden, was bei, insgesamt gesehen, zu - schlecht wärmeleitenden Materialien für große Teile des Gehäuses erhebliche Schwierigkeiten macht, z.B. bei aus Korrosionsschutzgründen gewähltem Edelstahl für den Boden oder für die ganze Bodenwanne -ganz besonders wenn eine große Vielzahl solcher Gehäuse dicht gepackt eng nebeneinander auf einer Platte befestigt werden, so daß die Kühlung im wesentlichen nur über den Außendeckel möglich ist. Außerdem sollen die er- findungsgemäßen Maßnahmen auch sine beacht- liche Wärmekapazität nahe genug beim Schaltungsbauteil erzeugen, um kurzzeitige sehr hohe Verlustleistungsspitzen aufzufangen.

Diese Aufgabe wird erfindungsgemäß durch die im Patentanspruch 1 angegebenen Maßnahmen gelöst.

Die in den Unteransprüchen angegebenen zusätzlichen Maßnahmen gestatten, zusätzliche Vorteile zu erreichen, nämlich die Maßnahmen gemäß Patentanspruch

2 und 3, einen besonders niedrigen Aufwand aufbringen zu müssen;

4, unter erschwerten Voraussetzungen einen niedrigen Wärmeübergangswiderstand zwischen dem Schaltungsbauteil -oder einem Baukörper davon -einerseits und dem -bevorzugt Bodenbe- reich vom -Auskleidungsblech andererseits errei- chen zu können;

5, selbst bei Massenfertigung mit besonders wenig Aufwand, trotz großer Herstellungstoleranzen eines Innendeckels, einen kleinen Wärmeübergangswinderstand zwischen dem Auskleidungsblech und dem Außendeckel erreichen zu können;

6, Zwischenwände gleichzeitig sowohl zur Verbesserung der Kühlung als auch zur Abschirmung zwischen verschliedenen Baukörpern des Schaltungsbauteils ausnutzen zu können, sowie

7, den Wärmeübergangswiderstand zwischen dem Auskleidungsblech und den Außendeckel sehr kelein machen zu können, ohne enge Herstellungstoleranze für das Auskleidungsblech und den Außendeckel einhalten zu müssen.

Die Erfindung und ihre Weiterbildungen werden anhand der beiden Figuren weiter erläutert, wobei die Figur

1 einen senkrechten Schnitt durch ein von der Seite betrachtetes , einen optoelektronischen Wandler enthaltendes Gehäusebeispiel der Erfindung, und

2 vergrößert ein Detail einer Weiterbildung in Draufsicht zeigen.

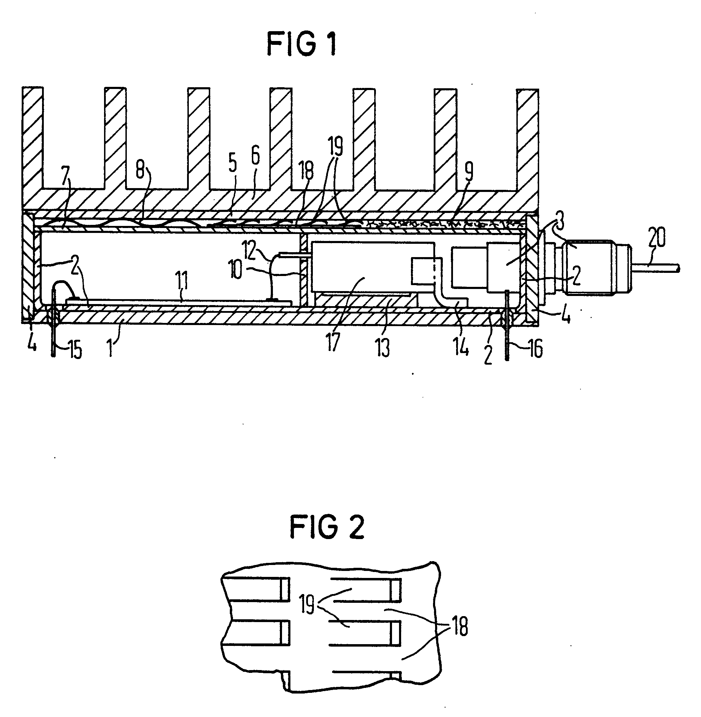

Die Fig. 1 zeigt ein Beispiel eines metallischen, aber relativ schlecht wärmeleitenden Gehäuses 1, 4, 5, 6 , welches eine Bodenwanne 1, 4 mit Boden 1 und Seitenwänden 4, sowie einen -bevorzugt hermetisch dicht -auf der Bodenwanne 1, 4 befestigten Außendeckel 5, 6 mit Außendeckelplatte 5 und -z.B. auf die Außendeckelplatte 5 geschraubtem -Kühlrippenteil 6 enthält. Im Gehäuse ist ein elektrisches, im Betrieb Verlustwärme abgebendes Schaltungsbauteil 11, 17 angebracht, welches seinerseits z.B. durch eine Infrarot-Lichtsendediode 17 und einen vorgeschaltetem Halbleiter- Treiber-Chip 11, also hier durch zwei getrennte Baukörper 11, 17 gebildet wird. Das Schaltungsbauteil 11, 17 dient im gezeigten Beispiel nämlich als optoelektronischer Wandler eines optoelektronischen Kommunikationssystems, bei welchem das Schaltungsbauteil 11, 17 bzw. seine hier am Boden 1 befestigten Baukörper 11, 17 nahe der dann höchstzulässigen Betriebstemperatur betrieben werden sollen und dazu sorgfältig durch sehr gezielte Maßnahmen zu kühlen sind.

Das Gehäuse enthält ferner die elektrischen Versorgungsleitungen, von denen die Figur symbolisch nur eine Leitung 12 zwischen den beiden Baukörpern 11, 17 sowie die beiden jeweils mittels Glas gegen den metallischen Boden 1 isolierten Zuleitungen, nämlich 15 zum Treiber-Chip 11 sowie 16 zur Diode 17 zeigt. Das Gehäuse enthält ferner das Ende einer Glasfaser 20 mit deren Glasfaseranschluß 3 für die Lichtweiterleitung.

Das hier im wesentlichen aus den beiden Baukörpern 11, 17 bestehende Schaltungsbauteil 11, 17 ist -hier jeder Baukörper 11, 17 für sich -am Boden 1 der Bodenwanne 1, 4 befestigt. Die Verlustwärme soll weitgehend über den gut wärmeleitenden Außendeckel 5, 6 als Wärmeleitkörper 5, 6 an die Außendeckel-Außenoberfläche, und von dort weiter an die das Gehäuse umströmende Kühlluft abgegeben werden.

Die Bodenwanne 1, 4 dieses Beispiels besteht aus relativ schlecht wärmeleitendem Material, so daß normalerweise die Ableitung der Verlustwärme vom Schaltungsbauteil, hier von dessen zwei Baukörpern 11, 17, zur Kühlluft zu schlecht wäre, besonders wenn zumindest einer der beiden Baukörper 11 oder 17 bereits nahe bei seiner höchstzulässigen Betriebstemperatur betrieben werden soll. Die Bodenwanne besteht also z.B. aus Edelstahl mit einer Wärmeleitfähigkeit von z.B. nur 15 W/m.K oder aus FeNi-oder FeNiCo-Legierungen (Vacodil oder Vacon) von z.B. zwischen 10 bis 16,7 W/m.K.

An sich kann man zur Verbesserung der Wärmeableitung zusätzlich auch sonstige nicht im vorleigender Hauptanspruch genannte Maßnahmen durchführen, z.B. jene in den älteren, nicht vorveröffentlichten Europäischen Anmeldungen 85 10 9825.1 (VPA 84 P 1584 E) und 85 10 9827.7 (VPA 84 P 1583 E) beschriebenen Maßnahmen sowie die Maßnahmen, welche in der prioritätsgleichen, mit der vorliegenden Anmeldung einereichten Deutschen Anmeldung P .. .. ..... (VPA 85 E 1747 DE = VPA 85 P 1588 DE) beschrieben sind.

Die Erfindung betrifft eine andere, weitere mögliche Maßnahme. Gemäß der Erfindung wird nämlich, vgl. Fig. 1, zumindest ein Teil sowohl der Innenoberfläche des Bodens 1 als auch der Bodenwanne-Seitenwände 4 der Bodenwanne 1, 4 mit einem gut wärmeleitendem Auskleidungsblech 2, z.B. aus Kupfer von z.B. 385 W/m.K, ausgekleidet, wobei dieses Ausksleidungsblech 2 jeweils einen gut wärmeleitenden Übergangsabschnitt sowohl zum Schaltungsbauteil 11, 17 hin als auch einen zum Wärmeableitkörper 5, 6 hin aufweist. Bevorzugterweise hat das Auskleidungsblech selbst auch eine Wannenform, ferner z.B. Aussparungen, z.B. für Zuleitungen 15, 16, sowie oben zum Außendeckel 5, 6 hin einen ebenen Rand, der als ebene Auflagefläche dienen kann, vgl. Fig. 1. Ein solcher Auf bau des Gehäuses erzeugt auch eine hohe Wärmekapazität nahe beim Schaltungsbauteil, benötigt zuden wenig Aufwand und ist daher für die Massenfertigung geeignet, ganz besonders dann, wenn zusätzlich das Auskleidungsblech 2 als eigener massiver vorgefertigter Gehäusebestandteil in die Bodenwannd 1, 4 gesteckt ist. Vorteilhafterweise . haben übrigens Kupfer und Edelstahl sehr ähnliche linear Wärmeausdehungs-Koeffizienten - (Cu $17,7.10^{-6}K^{-1}$ und CrNi-Stahl z.B. $16.10^{-6}K^-$s1), so daß das Auskleidungsblech 7 über sehr große Temperaturbereiche, z.B. -40° .... + 125°C gleichbleibend fest in der Bodenwanne 1,4 haftet.

Die beiden Übergangsabschnitte können jeweils verschieden aufgebaut werden. Besonders günstig und aufwandsarm erwies sich ein Aufbau des Gehäuses, bei welchem vgl. Fig. 1, das Schaltungsbauteil, hier der Treiber-Chip 11 direkt auf einem Auskleidungsblech-Abschnitt, welcher selbst den Übergangsabschnitt darstellt, befestigt ist, wobei dieser Auskleidungsblech-Abschnitt zwischen dem Schaltungsbauteil 11 und dem Boden 1 liegt.

Man kann jedoch auch bei Bedarf, vgl. Fig. 1, auch zwischen dem Schaltungsbauteil, hier der Lichtsendediode,und dem Auskleidungsblech 2 eine gut wärmeleitende, massive. Wärmeleitbrücke 13, 14 als Übergangsabschnitt einfügen, -wobei diese Wärmeleitbrücke, vgl. 13,zusätzlich als Sockel für das betreffende Schaltungsbauteil/Baukörper 11 dienen kann, oder als wärmeableitende seitliche Lasche oder Stütze 14.

Einen besonders niedrigen Wärmeübergangswiderstand und besonders große Toleranzen der Maß sind für die Bauteile im Übergangsbschnitt zum durch den Außendeckel 5, 6 gebildeten Wärmeableitkörper 5, 6 dadurch erreichbar, daß deckelnahe Oberflächen des Auskleidungsbleches 2, vgl. Fig. 1, die Auflagefläche für einen gut wärmeleiten den Innendeckel 7 bilden, wobei der Innendeckel 7 und ein Federkörper 8, 9, 18, 19 einen Übergangsabschnitt bilden, indem zwischen dem Innendeckel 7 und der Innenoberfläche des Außendeckels 5, 6 ein hochelastischer, gut wärmeleitender Federkörper 8, 9, 18, 19 angebracht ist.

Der Innendeckel 7 besteht bevorzugt aus hochelastischem Material, z.B. aus einer CuNiBe-Legierung, damit er möglichst großflächig, also mit niedrigem Wärmeübergangswiderstand, auf dem Auskleidungsblech 2 aufliegt.

Der Federkörper, vgl. Fig. 1, kann hierbei verschieden hergestellt werder. Z.B. hat er die Form eines Wellbleches 8, das aus gut wärmeleitendem Federblech besteht, z.B. aus einer CuNiBe-Legierung mit z.B. 230 W/m.K Wärmeleitfähigkeit.

Der Federkörper hat einen noch niedrigeren Wärmewiderstand, wenn er aus einem Federblech 18 besteht, vgl. Fig. 1 und 2, in welches hinsichtlich Beigung und Torsion besonders elastische Fiederzungen 19 gestanzt sind, die sich gut an ihre Auflagefläche -an der Innenoberfläche der Außendeckelplatte 5, oder bei Bedarf auch an die betreffende Oberfläche des Innendeckels 7 -mit hohem Auflagedruck anschmiegen. Auch dieses Fiederzungen-Federblech 18, 19 kann aus sehr gut wärmeleitenden hochelastischen CuNiBe-Legierung hergestellt werden.

Der Federkörper kann auch aus einem Filz 9 aus Metallfäden, z.B. aus Cu-Fäden bestehen, wobei solche Filze leicht auf das gewünschte Maß zu schneiden und leicht in die Gehäuse einlegbar sind.

Wenn das Schaltungsbauteil aus mehreren, voneinander hochfrequenzmäßig abzuschirmenden Baukörpern besteht, vgl. 11 und 17 in Fig. 1, dann kann man in das Auskleidungsblech 2 eine aus gut wärmeleitendem Material bestehende Zwischenwand 10 zur Bildung von mehreren, voneinander elektrisch abgeschirmten Kammern im Gehäuse-Inneren einfügen, wobei eine so eingefügte Zwischenwand 10 zusätzlich zur Wärmeableitung zwischen dem Boden des Auskleidungsbleches 2 und dem Außendeckel 5, 6 -bzw. Innendeckel 7 -mitausgenutzt werden kann.

Wenn, wie im gezeigten Beispiel, das Gehäuse mehrere Baukörper als Schaltungsbauteil enthält, können auch mehrere verschiedene Auskleidungsbleche im Gehäuse angebracht werden, welche jeweils mit einem Teil der Baukörper wärmeleitend verbunden werden und welche jeweils über eigene Wärmeleitkörper zu eigenen Gehäuse-Oberflächen hin wärmeleitend verbunden sind. Dann ist es möglich, daß die einzelnen Auskleidungsbleche untereinander verschiedene Temperaturen aufweisen, wodurch auch die Betriebstemperaturen der einzelnen Baukörper verschieden gewählt werden können. Diese Anbringung mehrerer, dann untereinander nicht gut wärmeleitend verbundener Auskleidungsbleche ist also besonders günstig, wenn jeder der Baukörper für sich jeweils bis nahe seiner höchstzulässigen Betriebstemperatur betrieben werden soll, obwohl alle diese Baukörper und alle ihre Auskleidungsbleche im selben, einzigen Gehäuse angebracht sind.

Bezugszeichenliste

1 Boden der Bodenwanne
2 Auskleidungsblech
3 Glasfaseranschluß
4 Seitenwand der Bodenwanne
5 Außendeckel / Wärmeableitkörper
6 Außendeckel / Wärmeableitkörper
7 Innendeckel
8 Federkörper
9 Federkörper
10 Zwischenwand
11 Schaltungsbauteil / Treiber-Chip
12 Versorgungsleitung
13 Wärmeleitbrücke

14 Wärmeleitbrücke
15 Versorgungsleitung
16 Versorgungsleitung
17 Schaltungsbauteil / Infrarot-Lichtsendediode
18 Ferderkörper
19 Federkörper / Fiederzungen
20 Glasfaser

## Ansprüche

1. Gehäuse(1, 4, 5, 6) mit einer Bodenwanne(1, 4) und mit einem -bevorzugt hermetisch dicht -auf der Bodenwanne (1, 4) aufsitzendem Außendeckel-(5, 6) für ein elektrisches, im Betrieb Verlustwärme abgebendes Schaltungsbauteil(11, 17), z.B. für eine Lichtsendediode(17) und/oder für einen Halbleiter-Chip(11), wobei

-das Schaltungsbauteil(11, 17) am Boden(1) der Bodenwanne (1, 4) befestigt ist, und

-die Verlustwärme zumindest zu einem erheblichen Teil über einen Wärmeableitkörper(5, 6) des Gehäuses(1, 4, 5, 6) an eine Gehäuse-Außenoberfläche, bevorzugt über den gut wärmeleitenden Außendeckel(5, 6) als Wärmeableitkörper(5, 6) an die Außendeckel(6)-Außenoberfläche, und von dort weiter an ein das Gehäuse umströmendes Kühlmedium, bevorzugt Kühlluft, abzugeben ist,

z.B. für einen elektrisch-optischen Wandler eines optoelektronischen Kommunikationssystems mit einem Schaltungsbauteil(11, 17), welches gleichzeitig sowohl eine gut zu kühlende Infrarot-Lichtsendediode(17) als auch einen gut zu kühlenden Treiber-Chip(11) sowie elektrische Versorgungsleitungen(12, 15, 16) enthält, und mit einen Glasfaseranschluß(3, 20) zur Lichtweiterleitung,

**dadurch gekennzeichnet**, daß

-zumindest ein Teil sowohl der Boden(1)-Innenoberfläche als auch der Bodenwanne-Seitenwände-(4) der, insgesamt gesehen, relativ schlecht wärmeleitenden Bodenwanne(1, 4) mit einem gut wärmeleitenden Auskleidungsblech(2) ausgekleidet ist, und

-das Auskleidungsblech(2) jeweils einen gut wärmeleitenden Übergangsabschnitt sowohl zum Schaltungsbauteil(11, 17) hin als auch einen zum Wärmeableitkörper(5, 6) hin aufweist.

2. Gehäuse nach Patentanspruch 1,

**dadurch gekennzeichnet** , daß

-das Auskleidungsblech(2) als eigener massiver Gehäusebestandteil in die Bodenwanne(1, 4) gesteckt ist.

(Fig.1)

3. Gehäuse nach Patentanspruch 1 oder 2,

**dadurch gekennzeichnet** , daß

-das Schaltungsbauteil(11) direkt auf einem Auskleidungsblech(2)-Abschnitt, welcher selbst einen Übergangsabschnitt darstellt, befestigt ist, und

-der Auskleidungsblech(2)-Abschnitt zwischen dem Schaltungsbauteil(11) und dem Boden(1) liegt.

(Fig.1)

4. Gehäuse nach einem der vorhergehenden Patentansprüche,

**dadurch gekennzeichnet** , daß

-zwischen dem Schaltungsbauteil(17) und dem Auskleidungsblech (2)eine gut wärmeleitende, massive Wärmeleitbrücke(13, 14) als Übergangsabschnitt eingefügt ist.

(Fig.1)

5. Gehäuse nach einem der vorhergehenden Patentansprüche,

**dadurch gekennzeichnet** , daß

-deckelnahe Oberflächen des Auskleidungsbleches(2) die Auflagefläche für einen gut wärmeleitenden Innendeckel (7) bilden, und

-der Innendeckel(7) und ein Federkörper(8, 9, 18, 19) einen Übergangsabschnitt bilden, indem

--zwischen dem Innendeckel(7) und der Innenoberfläche des einen Wärmeableitkörper bildenden Außendeckels(5, 6) ein hochelastischer, gut wärmeleitender Federkörper(8, 9, 18, 19) angebracht ist.

(Fig.1)

6. Gehäuse nach Patentanspruch 5,

**dadurch gekennzeichnet** , daß

-der Federkörper(18, 19) ausgestanzt aber noch an ihm hängend Fiederzungen (19) aufweist

(Fig.1 + 2)

7. Gehäuse nach einem der vorhergehenden Patentansprüche,

**dadurch gekennzeichnet** , daß

-das Auskleidungsblech(2) zumindest eine aus gut wärmeleitendem Material bestehende Zwischenwand(10) zur Bildung von mehreren, voneinander elektrisch abgeschirmten Kammern im Gehäuse-Inneren aufweist.

(Fig.1)

8. Gehäuse nach einem der vorhergehenden Patentansprüche,

**dadurch gekennzeichnet** , daß

-mehrere Wärmeauskleidbleche(2), welche schlecht wärmeleitend miteinander verbunden sind, angebracht sind, -jedes Auskleidungsblech(2) jeweils nur mit eigenen Baukörpern(11) des Schaltungsbauteils(11, 17) gut wärmeleitend verbunden sind,

-die mit verschiedenen Auskleidungsblechen gut wärmeleitend verbundenen Baukörper(11, 17) untereinander schlecht wärmeleitend verbunden sind, und

-jedes der Auskleidungsbleche mit eigenen Gehäuse-Außenoberflächen gut wärmeleitend verbunden sind.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 394 679 (F.Z. HAWRYLO) <br> * Insgesamt * | 1,2,4 | H 01 L 33/00 <br> G 02 B 6/42 |
| A | IBM TECHNICAL DISCLOSURE BULLETIN, Band 20, Nr. 7, Dezember 1977, Seiten 2635,2636, New York, US; F.A. SHOTT: "Boat thermal enhancement for semiconductor chips and modules" * Insgesamt * | 1-3 | |
| A | IBM TECHNICAL DISCLOSURE BULLETIN, Band 23, Nr. 9, Februar 1981, Seiten 4095,4096, New York, US; E.W. KUNKLER et al.: "Module with removable heat transfer members" * Insgesamt * | 1,4,7, 8 | |
| A | EP-A-0 097 782 (IBM CORP.) <br> * Insgesamt * | 1,5,6 | **RECHERCHIERTE SACHGEBIETE (Int. Cl.4)** <br> H 01 L <br> G 02 B <br> H 05 K |
| A | EP-A-0 111 264 (SIEMENS AG) <br> * Seite 4, Zeile 21 - Seite 8, Zeile 8; Abbildung 1 * | 1 | |

Der vorliegende Recherchenbericht wurde für alle Patentansprüche erstellt.

| Recherchenort | Abschlußdatum der Recherche | Prüfer |
|---|---|---|
| DEN HAAG | 03-10-1986 | VISENTIN A. |